# EUROPÄISCHE PATENTSCHRIFT

(11) **EP 0 412 343 B1**
(45) Veröffentlichungstag und Bekanntmachung des Hinweises auf die Patenterteilung: **21.02.1996**
(21) Anmeldenummer: 90114024.4
(22) Anmeldetag: 21.07.1990
(51) Int. Cl.: H04L 12/56

(54) **Koppelnetz und Koppelnetzmodul für ein ATM-System**
Switching network and module for an ATM-system
Réseau de commutation et module pour un système ATM

(30) Priorität: 09.08.1989 DE 3926301; 29.06.1990 DE 4020775
(43) Veröffentlichungstag der Anmeldung: 13.02.1991
(73) Patentinhaber: Alcatel SEL Aktiengesellschaft, D-70435 Stuttgart (DE); ALCATEL N.V., NL-1077 XX Amsterdam (NL)
(72) Erfinder: Schrodi, Karl, D-7258 Heimsheim (DE)
(74) Vertreter: Brose, Gerhard

(56) Entgegenhaltungen:
- EP-A- 0 274 793
- GLOBECOM Bd. 3, Dezember 1988, NEW YORK, US Seiten 1288 - 1292; Y. KATO ET AL.: 'EXPERIMENTAL BROADBAND ATM SWITCHING SYSTEM'
- IEEE JOURNAL ON SELECTED AREAS IN COMMUNICATION. Bd. 4, Nr. 8, November 1986, NEW YORK US Seiten 1373 - 1380; J.S. TURNER: 'Design of an Integrated Services Packet Network'

## Beschreibung

Die Erfindung betrifft ein Koppelnetz für ein ATM-System nach dem Oberbegriff des Anspruchs 1 und ein Koppelnetzmodul nach dem Oberbegriff des Anspruchs 4.

Ein solches Koppelnetz ist bekannt aus J .S. Turner, "Design of a Broadcast Packet Network", veröffentlicht in "Proceedings of INFOCOM '86", April 1986, Seiten 667 bis 675, sowie auch aus dem Dokument EP-A-0 274 793.

Als ATM-System (ATM = Asynchronous Transfer Mode) soll im vorliegenden Fall jedes System zur Übertragung von Information angesehen werden, bei dem die Information in gleich lange oder ungleich lange Teile zerlegt und jeweils mit einem verbindungsindividuellen Kopfteil als Folge von Paketen oder Zellen übertragen wird.

Das Koppelnetz nach dem Oberbegriff des Anspruchs 1 ist ein Koppelnetz mit mehrfacher Wegemöglichkeit. Das bekannte Koppelnetz ist ausschließlich aus 2 X 2-Koppelelementen aufgebaut. Allgemein werden aber Koppelnetzbausteine angestrebt, die eine möglichst große Zahl von Eingängen mit einer möglichst großen Zahl von Ausgängen beliebig verbinden können. Damit wird beispielsweise erreicht, daß nur wenige Stufen aufeinanderfolgen müssen, womit dann auch die Verzögerungen (delay), die Schwankungen der Verzögerungen (delay jitter) sowie die Zellverluste gering bleiben. Solche Koppelnetzbausteine sollen aber in integrierten Schaltungen zusammengefaßt sein, bei denen zumindest die Zahl der Anschlüsse nicht problemlos erweitert werden kann. Bei ATM-Systemen ist wegen der hohen übertragungsgeschwindigkeit, die bei etwa 150 Mbit/s oder gar 600 Mbit/s liegen soll, oft eine parallele Weitergabe der Daten erforderlich.

Es ist auch bereits bekannt, größere Koppelnetzbausteine zu ersetzen durch Koppelnetzmodule, die aus mehreren Koppelnetzbausteinen aufgebaut sind und nach außen wie ein großer Koppelnetzbaustein wirken. Insbesondere soll ein solches Koppelnetzmodul völlig blockierungsfrei sein.

Erfindungsgemäß wird deshalb das Koppelnetz nach der Lehre des Anspruchs 1 aufgebaut; es werden Koppelnetzmodule nach der Lehre des Anspruchs 4 verwendet. Vorteilhafte Ausgestaltungen sind den Unteransprüchen zu entnehmen.

Die Erfindung nützt die Besonderheiten des gesamten Koppelnetzes und der verwendeten Betriebsweise. Im hier verwendeten Koppelnetz und bei der hier verwendeten Betriebsweise, bei der der Verkehr bis herunter zur kleinsten Einheit, nämlich einer Zelle, gleichmäßig über das gesamte Koppelnetz verteilt wird, können nur lokale kurzfristige Blockierungen auftreten, die durch Zwischenspeicher aufgefangen werden können. Diese Lastaufteilung kann noch weiter verfeinert werden, wenn die zu vermittelnden Zellen innerhalb der Vermittlungsstelle in eine Mehrzahl kleinerer Zellen, je mit einem eigenen Zellkopf, aufgeteilt werden. Durch die zusätzlichen Zellköpfe wird allerdings die Gesamtlast erhöht.

Aufgrund der sehr gleichmäßigen Lastaufteilung kann nicht nur innerhalb eines jeden der beiden Teile des Koppelnetzes, sondern auch innerhalb einzelner Koppelnetzmodule auf eine Wegevielfalt verzichtet werden. Es genügt, wenn innerhalb eines Koppelnetzmoduls jeweils ein Weg von jedem Eingang zu jedem Ausgang möglich ist. Wenn die Kapazitäten der einzelnen Wege untereinander gleich sind, so genügt es, wenn die Summe der Kapazitäten aller Wege für die Aufnahme des Gesamtverkehrs ausreicht.

Bei gegebener Größe der einzelnen Koppelnetzmodule ist die Zahl der aufeinanderfolgenden Stufen so zu wählen, daß wie gefordert jeweils ein Weg möglich ist. Es zeigt sich, daß die Minimalzahl aufeinanderfolgender Stufen gleichzeitig optimal in dem Sinne ist, daß jede weitere Stufe nicht nur zusätzlichen Aufwand erfordert, sondern auch zusätzliche Verzögerungen, zusätzliche Schwankungen der Verzögerungen und zusätzliche Zellverluste zur Folge hat. Zusätzliche Wege, die bei vorgegebener Größe der Koppelnetzbausteine ohne Erhöhung der Stufenzahl möglich sind, haben keinen nachteiligen Einfluß. Sie sind gegebenenfalls sogar erforderlich, um die Gesamtkapazität zur Verfügung zu stellen.

Ein Nachteil der genannten Betriebsweise liegt darin, daß die zur selben Verbindung gehörenden Zellen nicht wie bei einer virtuellen Verbindung denselben Weg nehmen und sich somit überholen könnten. Eine einfache Möglichkeit, dies zu verhindern, ist schon seit langem bekannt. Sie besteht darin, am Eingang der Vermittlungsstelle bei dicht aufeinanderfolgenden zusammengehörigen Zellen die folgenden so lange zu verzögern, bis die jeweils vorausgehende Zelle nicht mehr überholt werden kann. Eine Eingangs-Umwandlungseinheit, die hierfür geeignet ist, wenngleich sie zu einem anderen Zweck gedacht ist, ist aus P 38 40 688.8 Cinternes Aktenzeichen D. Böttle - S. Wahl 13-2) bekannt.

Im folgenden wird die Erfindung anhand eines Ausführungsbeispiels unter Zuhilfenahme der bei liegenden Zeichnungen weiter erläutert.
- Fig. 1: zeigt den Aufbau eines erfindungsgemäßen Koppelnetzes.
- Fig. 2: zeigt eine andere Darstellung des Koppelnetzes nach Fig. 1, die der Verdeutlichung der Betriebsweise dient.
- Fig. 3: zeigt ein erfindungsgemäßes Koppelnetzmodul.
- Fig. 4: zeigt weitere Einzelheiten des Koppelnetzmoduls nach Fig. 3.
- Fig. 5: zeigt den Aufbau eines Koppelnetzbausteins.
- Fig. 6: bis Fig. 14 zeigen das Einschreiben von Zellen in den Pufferspeicher und das Auslesen daraus.

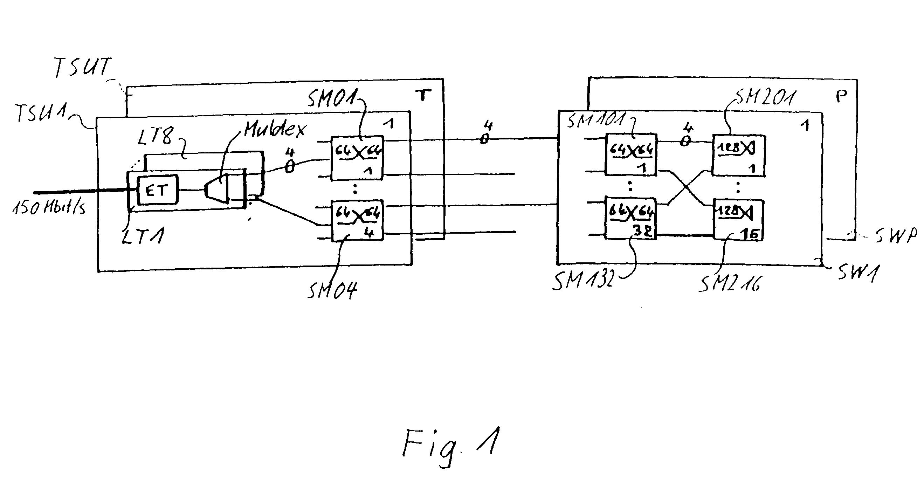

Das Koppelnetz nach Fig. 1 weist T Anschlußeinheiten TSU1 ... TSUT und P Vermittlungsebenen SW1 ... SWP auf. Im Beispiel ist T maximal 128, P maximal 16. Jede Anschlußeinheit weist bis zu 8 Leitungseinheiten LT1 ... LT8 und 4 Koppelnetzmodule SM01 ... SM04 auf. Jede Vermittlungsebene weist zwei Stufen von Koppelnetzmodulen auf; in der ersten Stufe sind bis zu 32 Koppelnetzmodule SM101 ... SM132, in der zweiten Stufe bis zu 16 Koppelnetzmodule SM201 ... SM216 enthalten.

Alle Koppelnetzmodule SM sind untereinander gleich aufgebaut. Sie weisen je 128 Eingänge und 128 Ausgänge auf, die nach außen als 128x128-Matrix wirken. Das gesamte Koppelnetz ist als Umkehr-Koppelanordnung ausgebildet, d.h., die Koppelnetzmodule SM0 und SM1 der beiden vorderen Stufen, die gleichzeitig als fünfte bzw. vierte Stufe wirksam sind, werden als zwei 64x64-Matrizen verwendet.

Die Leitungseinheiten LT weisen außer der Leitungsausrüstung ET noch je einen Multiplexer/Demultiplexer Muldex auf, der den ankommenden Verkehr auf die Koppelnetzmodule SM01 ... SM04 der jeweiligen Anschlußeinheit TSU aufteilt und in der Gegenrichtung den abgehenden Verkehr wieder zusammenfaßt. Alle Verkehrswege sind für 150 Mbit/s ausgelegt, je vier solcher Wege sind zwischen den Koppelnetzmodulen durch Multiplexen zu einem optischen Pfad mit 600 Mbit/s zusammengefaßt.

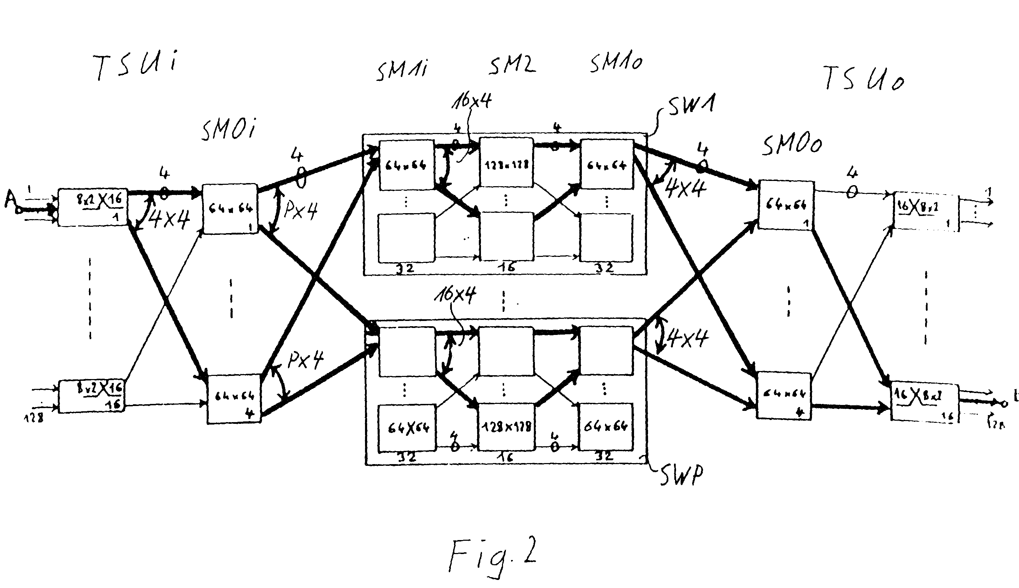

Fig. 2 zeigt dasselbe Koppelnetz in gestreckter Anordnung. Die Anschlußeinheiten TSU mit ihren Koppelnetzmodulen SMO erscheinen hier mit je einem eingangsseitigen Teil TSUi bzw. SMOi und einem ausgangsseitigen Teil TSUo bzw. SM0o. Entsprechend erscheinen die Koppelnetzmodule SM1 mit einem eingangsseitigen Teil SM1i und einem ausgangsseitigen Teil SM1o.

Fig. 2 zeigt im übrigen sehr schön den üblichen Koppelnetzaufbau mit einer ungeradzahligen Anzahl von Stufen, der auch als dreistufige Anordnung angesehen werden kann, wobei die mittlere Stufe in sich wieder dreistufig ist.

Durch dicke Pfeile sind in Fig. 2 all die Wege eingezeichnet, die von einem Eingang 4 zu einem Ausgang B möglich sind.

In der ersten Hälfte bis zu den Koppelnetzmodulen SM2 kann an jeder Verzweigungsmöglichkeit (Muldex, SM0i, SM1i) jeder beliebige Ausgang genommen werden. Erst in der zweiten Hälfte muß gezielt auf den gewünschten Ausgang B hin vermittelt werden. Es ist ohne weiteres einleuchtend, daß das gesamte Koppelnetz zu jedem Zeitpunkt sehr gleichmäßig ausgelastet ist, wenn alle an irgendeinem Eingang irgendeiner Anschlußeinheit ankommenden Zellen in der ersten Hälfte des Koppelnetzes völlig frei verteilt werden.

Ob die Verteilung in der ersten Hälfte jeweils zyklisch, zufällig oder in Abhängigkeit von einem Rückmeldungssignal erfolgt, das die Belastung der nachfolgenden Stufe anzeigt, ist zweitrangig.

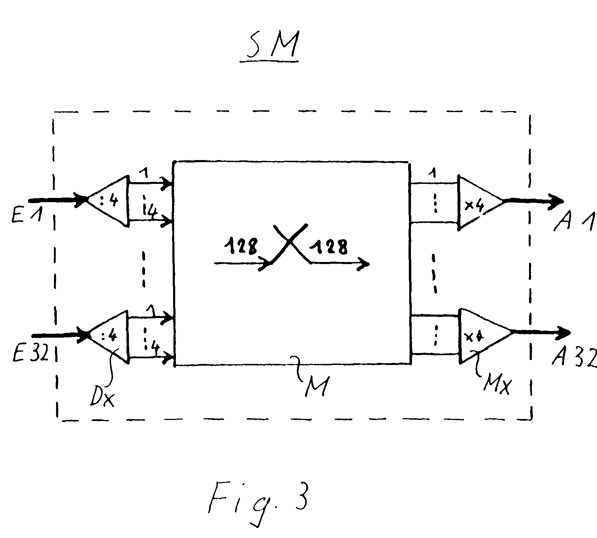

Fig. 3 zeigt den Grobaufbau eines Koppelnetzmoduls SM. Es weist 32 Eingangsleitungen E1, ..., E32 mit je einem Demultiplexer D1, ..., D32, 32 Ausgangsleitungen AI, ..., A32 mit je einem Multiplexer M1, ..., M32 und eine Matrix M auf. Jeder Demultiplexer Dx teilt einen optischen Datenstrom von 600 Mbit/s in vier elektrische mit je 150 Mbit/s. Die Multiplexer Mx fassen umgekehrt wieder zusammen.

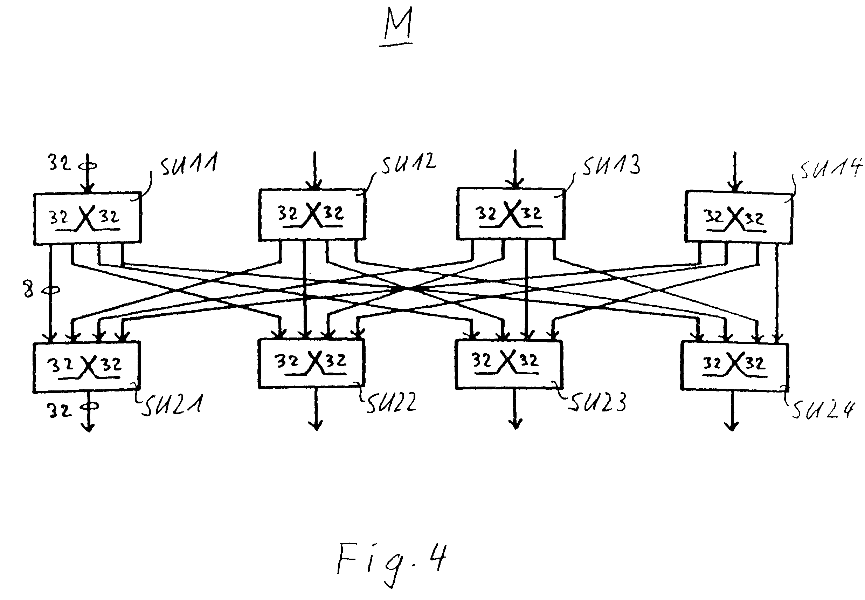

Fig. 4 zeigt den inneren Aufbau der Matrix M. Sie weist acht Koppelnetzbausteine auf, die in zwei Stufen SU11 ... SU14 und SU21 ... SU24 angeordnet sind. Jeder Koppelnetzbaustein weist 32 Eingänge und 32 Ausgänge für je 150 Mbit/s auf. Die Eingänge der ersten Stufe sind über die Demultiplexer mit den Eingangsleitungen E1, ..., E32 des Koppelnetzmoduls verbunden. Die Ausgänge der zweiten Stufe sind über die Multiplexer mit den Ausgangsleitungen A1, ..., A32 des Koppelnetzmoduls verbunden. Von jedem Koppelnetzbaustein der ersten Stufe geht ein Bündel von acht Leitungen zu jedem Koppelnetzbaustein der zweiten Stufe.

Der bei herkömmlichen Koppelanordnungen zu berücksichtigende Extremfall, daß nämlich alle Eingänge eines Koppelnetzbausteins der ersten Stufe voll ausgelastet sind und daß der gesamte Verkehr mehr als nur sehr kurzfristig zu einem einzigen Koppelnetzbaustein der letzten Stufe zu führen ist, kann hier nicht auftreten, da überhaupt keine längerdauernden gleichlaufenden Datenströme auftreten können. Auf eine Zwischenstufe zwischen Eingangs- und Ausgangsstufe kann deshalb verzichtet werden.

Im folgenden wird noch ein Koppelnetzbaustein beschrieben, wie er zur Realisierung des erfindungsgemäßen Koppelnetzes und des erfindungsgemäßen Koppelnetzmoduls benötigt wird:

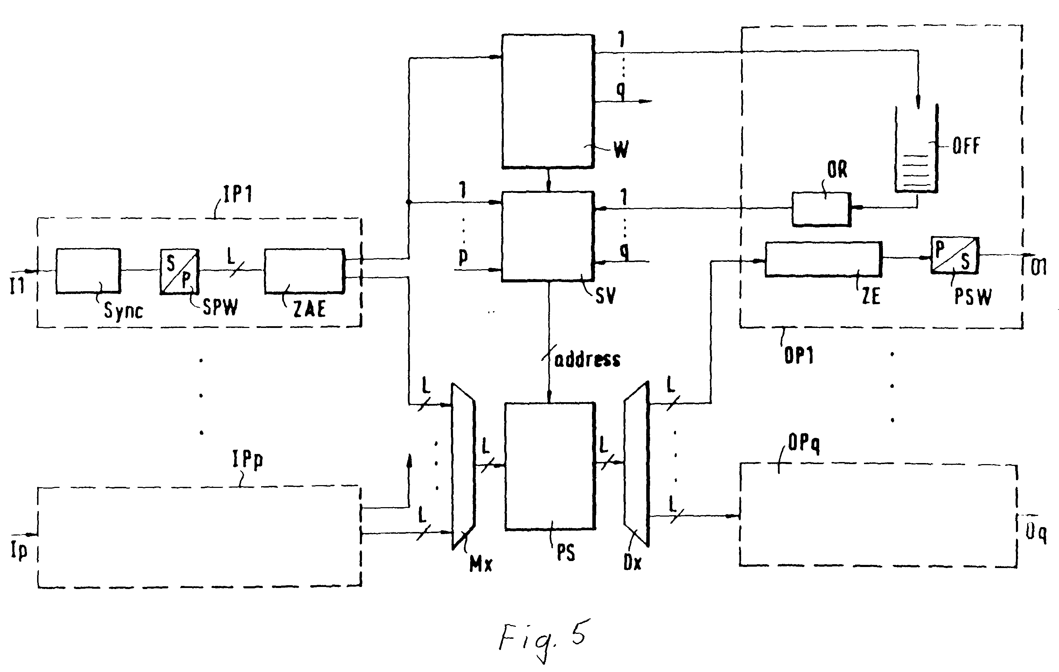

Der in Fig. 5 gezeigte Koppelnetzbaustein weist p Eingangseinheiten IP1, ..., IPp mit je einer Eingangsleitung I1, ..., Ip, einen Multiplexer Mx, einen Pufferspeicher PS mit C einzeln adressierbaren Speicherblöcken für je L Bits, einen Demultiplexer Dx, q Ausgangseinheiten OP1, ..., OPq, eine Speicherverwaltungseinheit SV, und einen Block W für die Wegewahl auf. Bevorzugt wird ein Koppelnetzbaustein mit p = q = 32, d.h. mit 32 Eingangs- und 32 Ausgangsleitungen. Für C und L sind derzeit Zahlenwerte von C = 256 und L = 50 im Gespräch. Die Größe der Speicherblöcke ist nicht völlig frei wählbar. Da aufgrund der hohen Verarbeitungsgeschwindigkeit zumindest intern eine parallele Verarbeitung erforderlich ist, muß die Größe der Speicherblöcke an die durch Parallelisierung entstandene Wortbreite angepaßt werden. Im Beispiel sind Wortbreite und Größe eines Speicherblocks identisch. Speicherblöcke, die gleichzeitig vier, acht, 16 oder mehr Wörter fassen, sind aber ebenfalls möglich. Was sinnvoll ist, hängt auch von der jeweiligen Zelllänge ab.

Die Eingangseinheit IP1 zeigt den inneren Aufbau der Eingangseinheiten etwas detaillierter. Die Eingangsleitung I1 führt auf eine Synchronisationseinrichtung SYNC, deren Ausgang auf einen Serien-Parallel-Wandler SPW und dessen Ausgang wiederum über eine Einheit ZAE zur Erkennung von Zellanfängen und -enden zur Eingangsseite des Multiplexers Mx: Die Einheit ZAE ist weiter mit je einem Eingang des Blocks W für die Wegewahl und der Speicherverwaltungseinrichtung SV verbunden.

Die Ausgangseinheit OP1 zeigt Details der Ausgangseinheiten. Die Ausgangsseite des Demultiplexers Dx ist über eine Einheit ZE zur Erkennung von Zellenden mit einem Parallel-Serien-Wandler PSW verbunden, dessen Ausgang mit der Ausgangsleitung O1 verbunden ist. Weiter ist ein Ausgabe-FIFO OFF und ein Ausgaberegister OR vorhanden. Das Ausgabe-FIFO OFF ist eingangsseitig mit einem Ausgang des Blocks W für die Wegewahl und ausgangsseitig mit dem Ausgaberegister OR verbunden, das wiederum bidirektional mit der Speicherverwaltungseinheit SV verbunden ist.

In Fig. 5 ist zur Verbindung der Eingangseinheiten IP1, ..., IPp mit den zentralen Einheiten Pufferspeicher PS, Speicherverwaltungseinheit SV und Block W für die Wegewahl der Multiplexer Mx und ein Netz von Einzelleitungen eingezeichnet. Der Datenstrom ist zu L Bit parallelisiert. Steuer- und Takt leitungen sind ebensowenig eingezeichnet wie die Stromversorgung. All dies sind Dinge, für die dem Fachmann genügend Lösungsmöglichkeiten bekannt sind, unter denen er wählen kann, wenn ihm bekannt ist, welche Informationen wo und wann auszutauschen sind. Insoweit gilt nichts anderes als für Vermittlungselemente für synchrone Systeme. Ein solches Vermittlungselement, das ein Bussystem zur Verbindung der Baugruppen untereinander aufweist, ist von J.M. Cotton et al in "SYSTEM 12, Digital-Koppelnetz", Elektrisches Nachrichtenwesen Band 56, Nummer 2/3, 1981, Seiten 148-160 beschrieben. Es wird darauf hingewiesen, daß ein Bussystem mit einer Mehrzahl von Sendern und einem Empfänger nichts anderes als ein Multiplexer ist. Entsprechendes gilt für die Ausgangsseite.

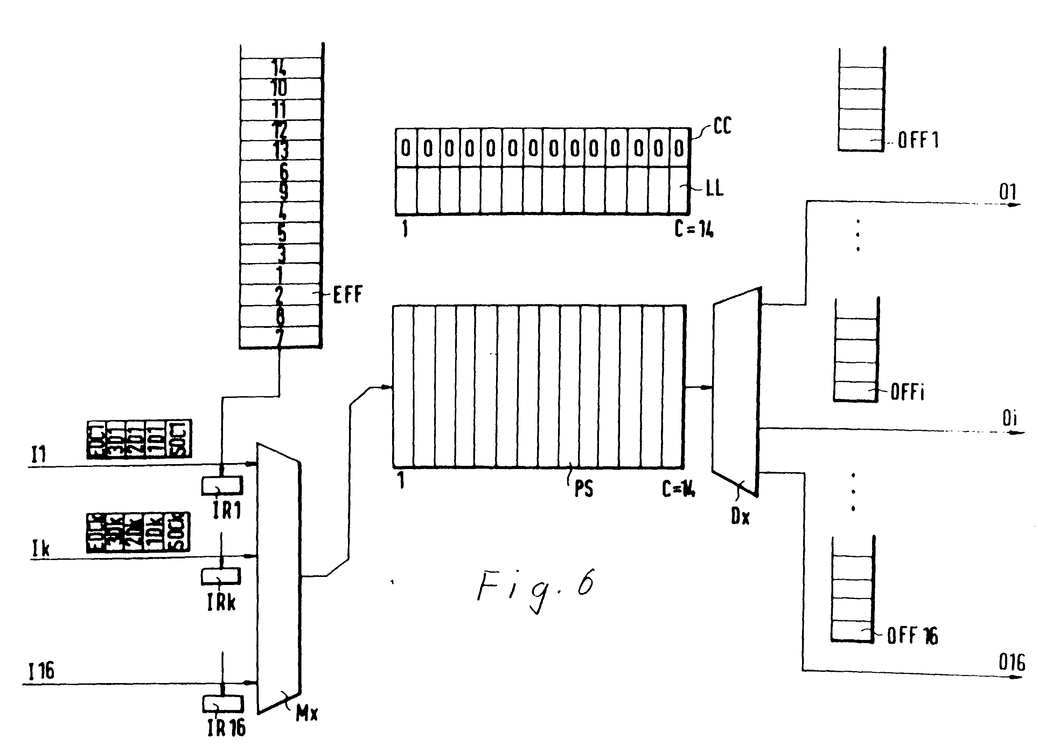

Anhand der Figuren 6 bis 14 wird nun der normale Vermittlungsvorgang an einem sehr vereinfachten Beispiel beschrieben. In diesem einfachen Beispiel weist der Pufferspeicher PS nur C = 14 Speicherblöcke auf, die zunächst alle leer sind. Die Speicherverwaltungseinheit SV ist durch tabellenartige Wiedergabe ihrer Speicher dargestellt. Der Kern der Speicherverwaltungseinheit SV ist ein Listenspeicher LL, der für jeden der C Speicherblöcke des Pufferspeichers PS einen Speicherplatz aufweist, der die gleiche Adresse trägt wie der zugeordnete Speicherblock und der die Adresse eines anderen Speicherblocks aufnehmen kann. Der Listenspeicher LL ist zunächst (Fig. 6) leer. Weiter ist in der Speicherverwaltungseinheit SV ein Speicher EFF für freie Speicherblöcke enthalten, der nach dem FIFO-Prinzip (first-in-first-out) arbeitet und der zunächst die Adressen sämtlicher Speicherblöcke des Pufferspeichers PS in zufälliger Reihenfolge enthält. Auch die Ausgabe-FIFOs, gezeichnet sind OFF1, OFFi und OFF16, sind zunächst leer. Tatsächlich enthält ein "leerer" Speicherplatz wie üblich irgendwelche Daten. Dies kann ein Wert sein, der ihn als leer kennzeichnet, es kann auch ein nun nicht mehr gültiger Wert von der letzten Benutzung her sein. Im letzten Fall muß auf andere Weise dafür gesorgt werden, daß er nicht mehr zur Ausgabe aufgerufen wird. Die Speicherverwaltungseinheit SV gemäß dem vorliegenden Ausführungsbeispiel weist neben dem Listenspeicher LL und mit diesem adressierbar noch C Speicherplätze eines Zählspeichers CC auf, der angibt, zu wievielen Ausgangseinheiten der Inhalt des zugeordneten Speicherblocks des Pufferspeichers PS noch auszugeben sind. Alle Speicherplätze des Zählspeichers CC stehen zunächst auf 0.

Auf den Eingangs leitungen I1 und Ik kommt nun je eine Zelle an. Weitere Zellen kommen in diesem Beispiel nicht an. Die Synchronisiereinrichtungen der beiden Eingangseinheiten IP1 und IPk wandeln, zusammen mit den jeweiligen Serien-Parallel-Wandlern, die Zellen in je fünf gleich lange Blöcke um. Der jeweils erste Block, SOC1 bzw. SOCk, beginnt mit einer Marke SOC (Start of Cell) für den Beginn einer Zelle. Der jeweils letzte Block, EOC1 bzw. EOCk, enhält eine Marke EOC (End of Cell) für das Ende einer Zelle. Die Marke EOC liegt beliebig innerhalb des letzten Blocks, dort nämlich, wo die von außen kommende Zelle tatsächlich aufhört. Die Synchronisiereinrichtung fügt hier noch Leerstellen an, um die Blöcke zu füllen. Der Rest der ersten Blöcke, die zweiten bis vierten Blöcke, 1D1, 2D1, 3D1 bzw. 1Dk, 2Dk, 3Dk, und die Anfänge der fünften Blöcke bis zur EOC-Marke enthalten die Dateninhalte der Zellen.

Durch den Multiplexer Mx werden die Eingangseinheiten zyklisch abgefragt. Die Einheiten ZAE in den Eingangseinheiten IP1 und IPk erkennen an den SOC-Marken, daß weiterzugebende Information anliegt. Aus dem Speicher EFF wird die Adresse 7 als die Adresse eines freien Speicherblocks in ein Eingangsregister IR1 übernommen und der erste Block SOC1 im Pufferspeicher PS unter der Adresse 7 abgelegt. Gleichzeitig geht die SOC-Marke an den Block W für die Wegewahl und an die Speicherverwaltungseinheit SV.

Die SOC-Marke enthält der Reihe nach für jede zu durch laufende Stufe des Koppelnetzes eine Angabe über den in dieser Stufe zu wählenden Ausgang. Durch Verschieben wird nach jeder Auswertung der für die nächste Stufe gültige Teil der Wegangaben innerhalb der SOC-Marke an die richtige Stelle gebracht. Die Wegeangabe kann dabei lauten: "Wähle irgendeinen Ausgang", oder "Wähle innerhalb einer vorgegebenen Gruppe von Ausgängen irgendeinen Ausgang", oder "Wähle einen ganz bestimmten vorgegebenen Ausgang". Durch die Festlegung der Wegeangaben innerhalb der SOC-Marke wird durch die Anschlußeinheiten die Betriebsweise des Koppelnetzes festgelegt.

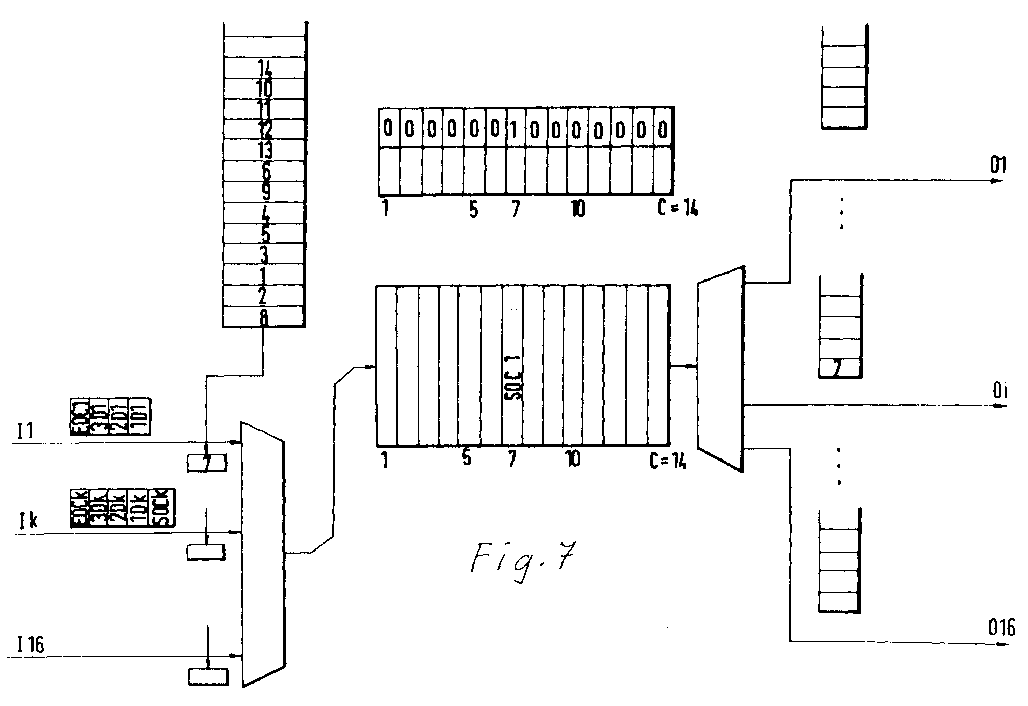

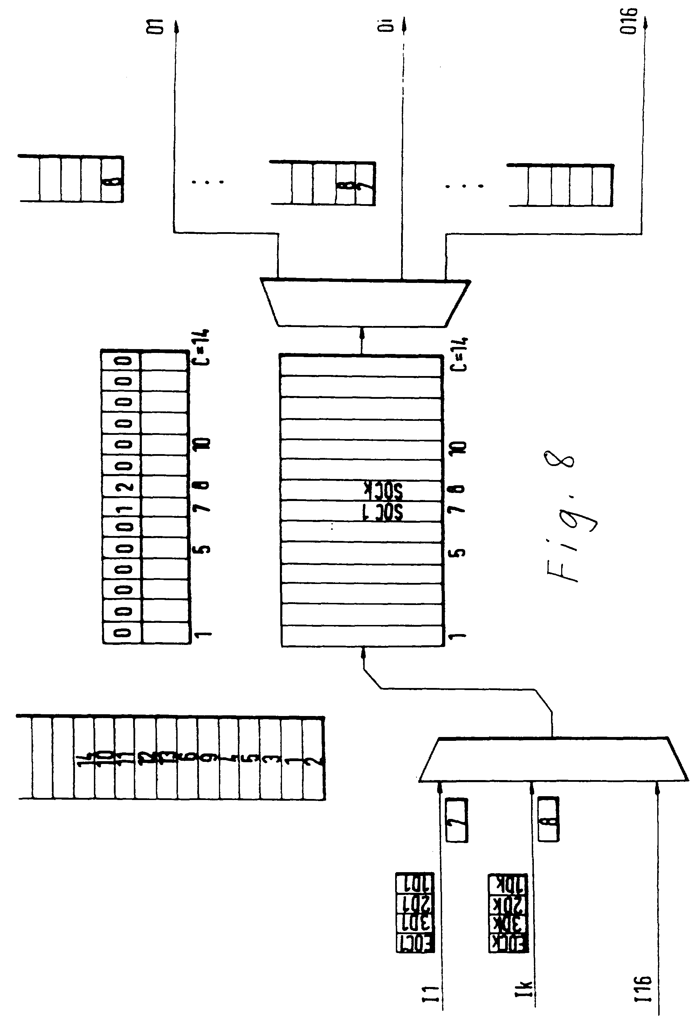

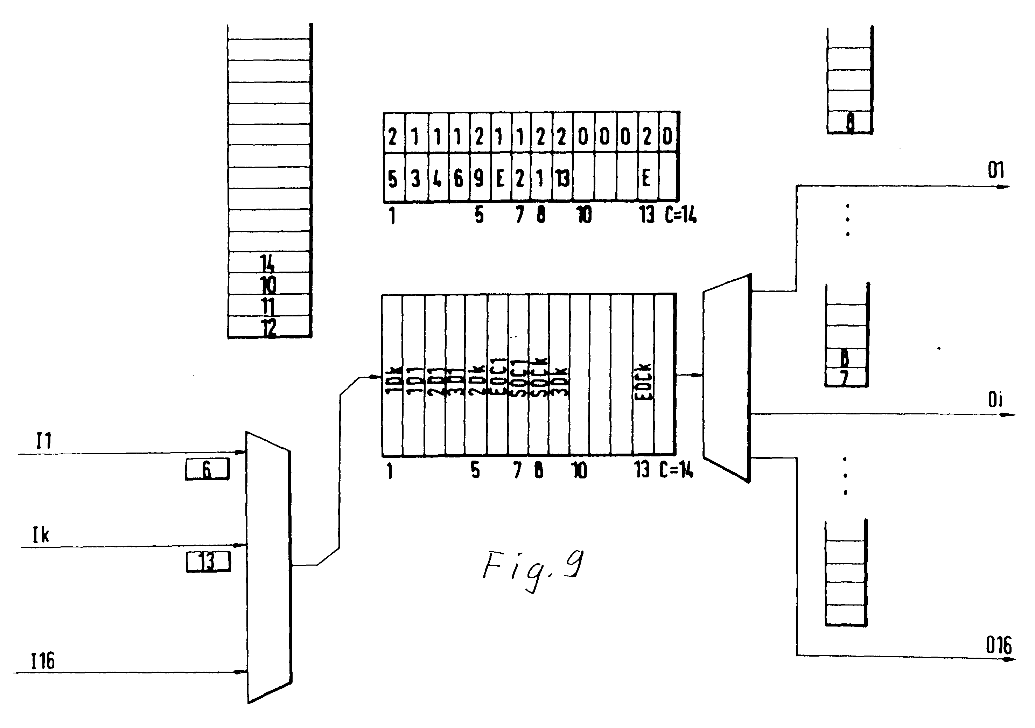

Im gezeigten Beispiel wird die Ausgangsleitung i festgelegt. Im Ausgabe-FIFO OFFi wird die Adresse 7 als Startadresse einer von der Ausgangseinheit OPi auszugebenden Zelle notiert. Im Zählspeicher wird unter der Adresse 7 eine "1" notiert. Jetzt ist der Zustand gemäß Fig. 7 erreicht.

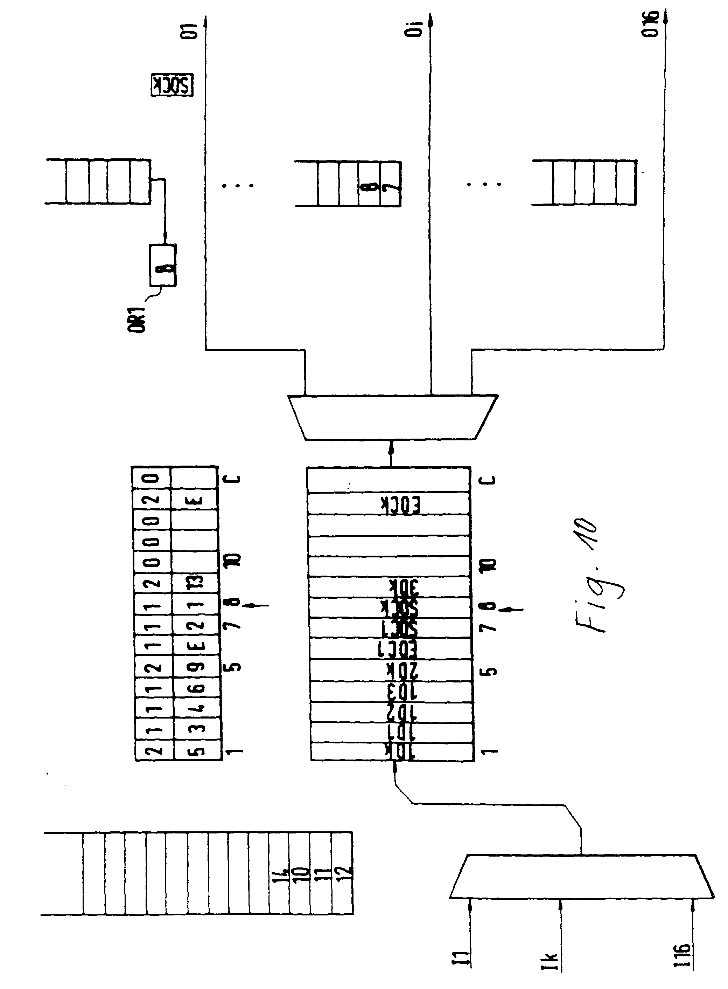

Der nächste in den Pufferspeicher PS zu übernehmende Block ist der Block SOCk von der Eingangseinheit IPk. Der Speicher EFF gibt an, daß dieser Block unter der Adresse 8 im Pufferspeicher abzuspeichern ist. Der Block W wertet die SOC-Marke dahingehend aus, daß diese Zelle sowohl zur Ausgangsleitung O1 als auch zur Ausgangsleitung Oi ausgegeben werden soll. Diese Möglichkeit der Mehrfachausgabe ist eine Besonderheit des hier beschriebenen Koppelfeldbausteins. Sie hat nichts mit dem erfindungsgemäßen Aufbau des Koppelnetzes und des Koppelnetzmoduls zu tun. Die Adresse 8 wird deshalb sowohl im Ausgabe-FIFO OFF1 als auch im Ausgabe-FIFO OFFi abgespeichert, in letzterem an zweiter Stelle hinter der 7. Der Block SOCk selbst wird im Pufferspeicher PS unter der Adresse 8 abgespeichert, der Zählspeicher CC erhält unter der Adresse 8 den Eintrag "2". Die "8" wird im Eingangsregister IRk gespeichert. Jetzt ist der Zustand gemäß Fig. 8 erreicht.

Als nächstes wird der Block 1D1 unter der nächsten freien Adresse "2" in den Pufferspeicher PS eingespeichert, im Zählspeicher CC wird unter Adresse 2 eine "1" eingetragen, im Listenspeicher wird unter der Adresse 7 eine "2" eingetragen. Die Adresse 7 wurde in IR1 als diejenige Adresse zwischengespeichert, unter der der vorangehende Block dieser Zelle abgespeichert wurde. In gleicher Weise werden die übrigen Blöcke aus der Eingangseinheit IP1 und IPk abgespeichert.

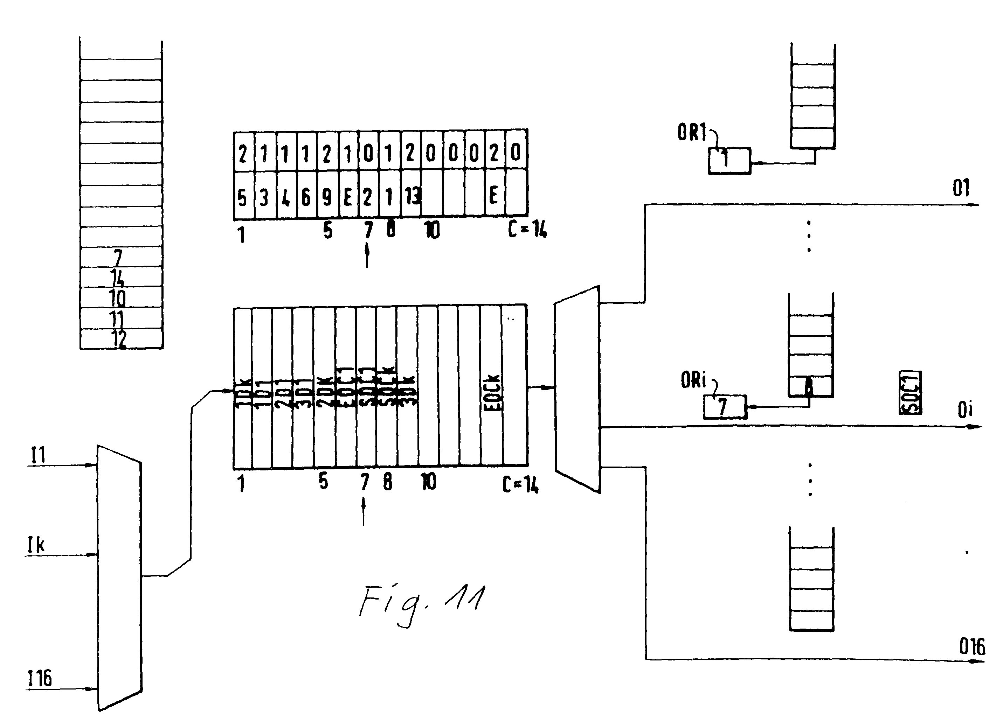

Am Ende der Eingabe, das in Fig. 9 dargestellt ist, ist die von I1 gekommene Zelle der Reihe nach unter den Adressen 7, 2, 3, 4 und 6 und die von Ik gekommene Zelle unter den Adressen 8, 1, 5, 9 und 13 abgespeichert. Der Speicher EFF weist nur noch vier freie Speicherblöcke aus. Der Listenspeicher LL enthält die o.g. Adressfolgen, wobei anstelle einer Folgeadresse für den jeweils letzten Block ein Sonderzeichen, hier "E", eingetragen ist.

Anhand der Fig. 10 bis 14 wird die Ausgabe der Zellen beschrieben, die sich an die komplette Eingabe anschließen soll. Die Ausgabe wird von den Ausgangseinheiten aus veranlaßt; diese werden hierzu zyklisch aktiviert.

Das Ausgabe-FIFO OFF1 zeigt an, daß über die Ausgangsleitung O1 eine Zelle auszugeben ist, deren erster Block unter der Adresse 8 im Pufferspeicher abgelegt ist. Diese Adresse 8 wird ins Ausgaberegister OR1 übernommen, die Adresse 8 an Pufferspeicher PS, Listenspeicher LL und Zählspeicher CC angelegt, der erste Block aus PS übernommen, die Folgeadresse "1" aus LL nach OR 1 übernommen und der Zählspeicher von "2" nach "1" dekrementiert, vergl. Fig. 10.

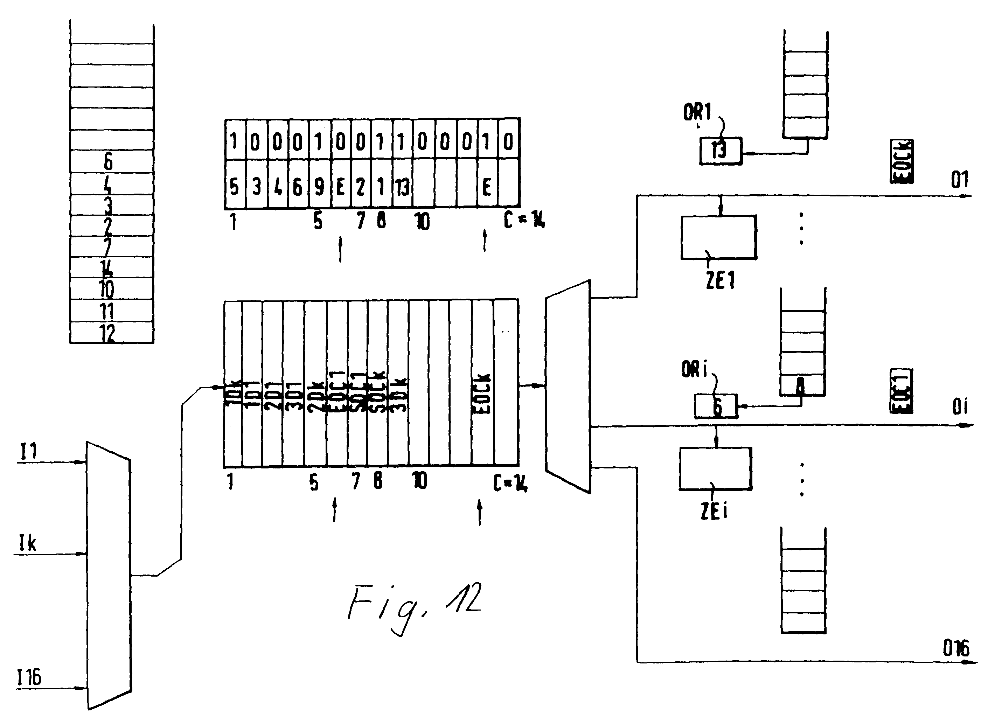

Fig. 11 zeigt die nächste Ausgabe, die von OPi veranlaßt wird. Die Anfangsadresse 7 wird von OFFi nach ORi übernommen, an PS, LL und CC angelegt, der erste Block aus PS ausgegeben, die Folgeadresse 2 nach ORi übernommen und CC von "1" nach "0" dekrementiert. Diese "0" gibt nun an, daß der Inhalt des Blocks 7 in PS nicht weiter benötigt wird; dieser Block ist nun frei, seine Adresse wird in den Speicher EFF für freie Speicherblöcke zurückgegeben.

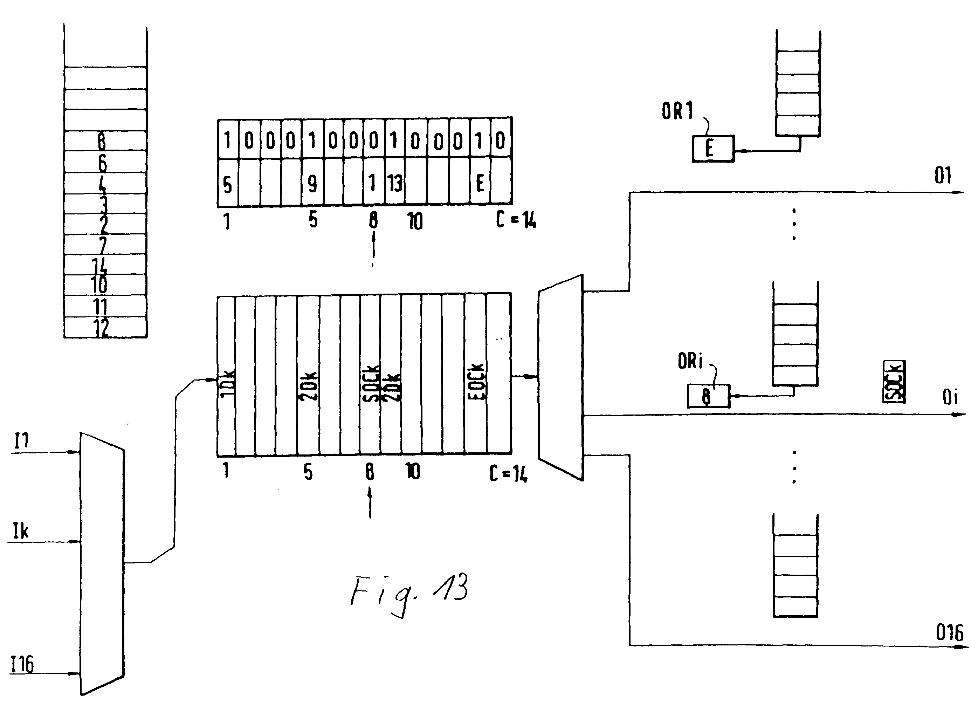

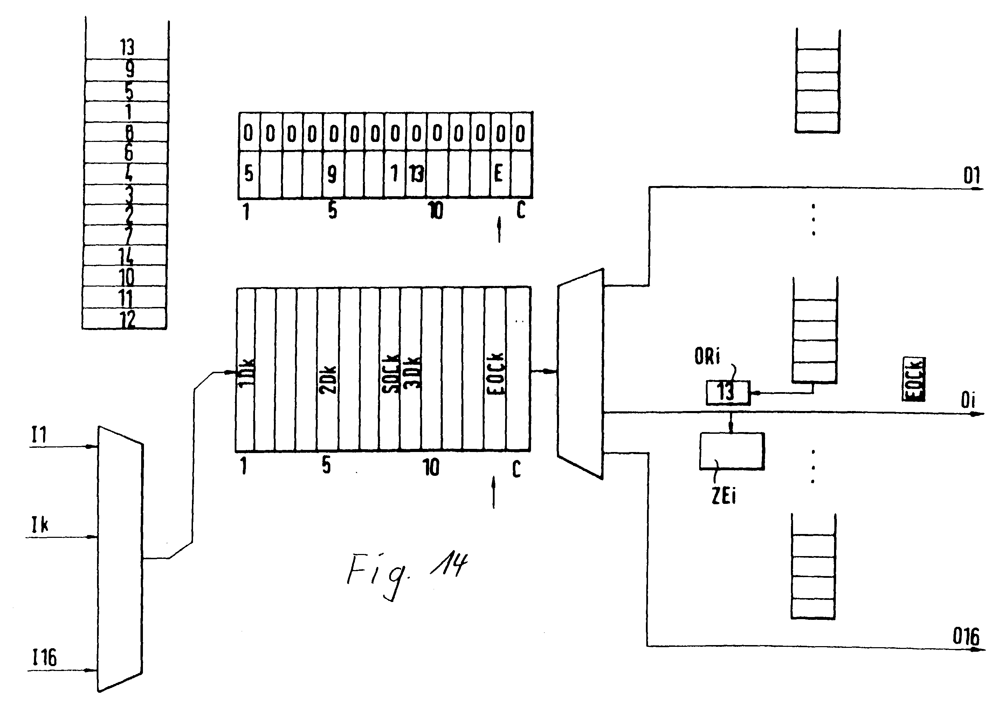

Fig. 12 zeigt den Zustand, der sich ergibt, wenn an O1 und Oi je eine Zelle ausgegeben ist. Sowohl mittels der Einheiten ZE1 und ZEi zur Erkennung von Zellenden als auch anhand der Inhalte der Ausgaberegister OR1 und ORi wird ein Zellende erkannt. Durch nicht eingezeichnete Baugruppen wird veranlaßt, daß Leerblöcke gesendet werden. OFFi zeigt aber an, daß noch eine weitere Zelle von der Ausgangseinheit OPi zu senden ist und daß deren erster Block unter der Adresse 8 in PS gespeichert ist. Deren Ausgabe beginnt mit dem Zustand in Fig. 13 und endet mit dem Zustand in Fig. 14.

Alle Blöcke sind nun ausgegeben, Pufferspeicher PS und Listenspeicher LL sind frei, der Zählspeicher CC weist überall eine "0" auf, der Speicher EFF enthält wieder die Adressen sämtlicher Blöcke von PS, wenn auch in anderer Reihenfolge; an allen Ausgangsleitungen werden Leerblöcke gesendet.

Eingaben und Ausgaben erfolgen in Wirklichkeit nicht in der beschriebenen Weise zeitlich getrennt, sondern können gleichzeitig ablaufen. Der Pufferspeicher PS wird als Dual-Port-RAM ausgeführt, so daß Ein- und Ausgänge unabhängig voneinander darauf zugreifen können. Das bedeutet insbesondere, daß die ersten Blöcke einer Zelle bereits ausgelesen werden können, bevor die letzten eingeschrieben worden sind. Somit wird eine sehr kurze Verzögerung der Zellen und eine möglichst kurze Belegung des Pufferspeichers PS ermöglicht.

## Patentansprüche

1. Koppelnetz für ein ATM-System, mit Koppeleinrichtungen (SM01, ..., SM04; SM101, ..., SM132; SM201, ..., SM216) mit Eingängen zum Empfang von Zellen, Ausgängen zum Senden von Zellen, Mitteln zur Übergabe einer an einem beliebigen Eingang empfangenen Zelle an einen beliebigen Ausgang, und Speichern (PS) zum Zwischenspeichern von Zellen, bei dem jede Zelle das Koppelnetz derart durchläuft, daß in einem ersten Teil in den durchlaufenen Koppeleinrichtungen die Ausgänge unabhängig vom Ziel der Zelle ausgewählt werden und in einem zweiten Teil die Ausgänge der durchlaufenen Koppeleinrichtungen in Abhängigkeit vom Ziel der Zelle ausgewählt werden,
**dadurch gekennzeichnet,**
daß die Koppeleinrichtungen Koppelnetzmodule (SM) sind, die aus zwei oder mehr Stufen bestehende Anordnungen von Koppelnetzbausteinen sind, daß jeder Koppelnetzbaustein (Fig. 5) zwei oder mehr Eingänge, zwei oder mehr Ausgänge, Mittel zur Übergabe einer an einem beliebigen Eingang empfangenen Zelle an einen beliebigen Ausgang und Speicher zum Zwischenspeichern von Zellen enthält, daß jeder Eingang (I1, ..., I16) eines Koppelnetzbausteins der ersten Stufe (SU11, ..., SU14) eines Koppelnetzmoduls mit einem der Eingänge (E1, ..., E32) dieses Koppelnetzmoduls verbunden ist, daß jeder Ausgang (O1, ..., O16) eines Koppelnetzbausteins der letzten Stufe (SU21, ..., SU24) eines Koppelnetzmoduls mit einem der Ausgänge (A1, ..., A32) dieses Koppelnetzmoduls verbunden ist, daß zwischen den Stufen die Ausgänge der Koppelnetzbausteine vorangehender Stufen so mit den Eingängen der Koppelnetzbausteine nachfolgender Stufen verbunden sind, daß von jedem Eingang des Koppelnetzmoduls zu jedem Ausgang des Koppelnetzmoduls ein Weg möglich ist und daß das Koppelnetzmodul genau soviele Stufen aufweist, daß dieser eine Weg möglich ist.

2. Koppelnetz nach Anspruch 1, dadurch gekennzeichnet, daß jedes Koppelnetzmodul (SM) aus einer aus zwei Stufen (SU11, ..., SU14; SU21, ..., SU24) bestehenden Anordnung von Koppelnetzbausteinen besteht und daß jeder Koppelnetzbaustein der ersten Stufe mit jedem Koppelnetzbaustein der zweiten Stufe verbunden ist.

3. Koppelnetz nach Anspruch 2, dadurch gekennzeichnet, daß jeweils mehrere Ausgänge eines Koppelnetzbausteins der ersten Stufe eines Koppelnetzmoduls mit mehreren Eingängen eines Koppelnetzbausteins der zweiten Stufe des Koppelnetzmoduls verbunden sind.

4. Koppelnetzmodul (SM) für das Koppelnetz nach Anspruch 1 mit einer Vielzahl von Eingängen (E1, ...,E32) zum Empfang von Zellen, einer Vielzahl von Ausgängen (A1, ..., A32) zum Senden von Zellen und Mitteln zur Übergabe einer an einem beliebigen Eingang empfangenen Zelle an einen beliebigen Ausgang,
**dadurch gekennzeichnet,**
daß es aus einer aus zwei oder mehr Stufen bestehenden Anordnung von Koppelnetzbausteinen besteht, daß jeder Koppelnetzbaustein (Fig. 5) zwei oder mehr Eingänge (I1, ..., I16), zwei oder mehr Ausgänge (O1, ..., O16), Mittel zur Übergabe einer an einem beliebigen Eingang empfangenen Zelle an einen beliebigen Ausgang und Speicher (PS) zum Zwischenspeichern von Zellen enthält, daß jeder Eingang (I1, ..., I16) eines Koppelnetzbausteins der ersten Stufe (SU11, ..., SU14) des Koppelnetzmoduls mit einem der Eingänge (E1, ..., E32) des Koppelnetzmoduls verbunden ist, daß jeder Ausgang (O1, ..., O16) eines Koppelnetzbausteins der letzten Stufe (SU21, ..., SU24) des Koppelnetzmoduls mit einem der Ausgänge (A1, ..., A32) des Koppelnetzmoduls verbunden ist, daß zwischen den Stufen die Ausgänge der Koppelnetzbausteine vorangehender Stufen so mit den Eingängen der Koppelnetzbausteine nachfolgender Stufen verbunden sind, daß von jedem Eingang des Koppelnetzmoduls zu jedem Ausgang des Koppelnetzmoduls ein Weg möglich ist und daß das Koppelnetzmodul genau soviele Stufen aufweist, daß dieser eine Weg möglich ist.

5. Koppelnetzmodul nach Anspruch 4, dadurch gekennzeichnet, daß es aus einer aus zwei Stufen (SU11, ..., SU14; SU21, ..., SU24) bestehenden Anordnung von Koppelnetzbausteinen besteht, daß jeder Koppelnetzbaustein (Fig. 5) mehrere Eingänge, mehrere Ausgänge, Mittel zur Übergabe einer an einem beliebigen Eingang empfangenen Zelle an einen beliebigen Ausgang und Speicher (PS) zum Zwischenspeichern von Zellen enthält, daß jeder Eingang eines Koppelnetzbausteins der ersten Stufe (SU11, ..., SU14) mit einem der Eingänge (I1, ..., I32) des Koppelnetzmoduls verbunden ist, daß jeder Ausgang eines Koppelnetzbausteins der zweiten Stufe (SU21, ..., SU24) mit einem der Ausgänge (O1, ..., O32) des Koppelnetzmoduls verbunden ist und daß jeder Koppelnetzbaustein der ersten Stufe mit jedem Koppelnetzbaustein der zweiten Stufe verbunden ist.

6. Koppelnetzmodul nach Anspruch 4 oder 5, dadurch gekennzeichnet, daß jeweils mehrere Ausgänge eines Koppelnetzbausteins einer vorangehenden Stufe mit mehreren Eingängen eines Koppelnetzbausteins einer nachfolgenden Stufe verbunden sind.

## Claims

1. Switching network for an ATM system comprising switches (SM01, ..., SM04; SM101, ..., SM132; SM201, ..., SM216) having inputs for receiving cells, outputs for transmitting cells, means for transferring a cell received at any input to any output, and memories (PS) for buffering cells, wherein during the passage of each cell through the switching network, the outputs of the traversed switches in a first portion of the switching network are selected independently of the destination of the cell, while the outputs of the traversed switches in a second portion of the switchinq network are selected in accordance with the destination of the cell,
**characterized in**
that the switches are switching-network modules (SM) which are two- or multi-stage arrangements of switching elements, that each switching element (Fig. 5) has two or more inputs, two or more outputs, means for transferring a cell received at any input to any output, and memories for buffering cells, and that each input (I1, ..., I16) of a switching element of the first stage (SU11, ..., SU14) of a switching-network module is connected to one of the inputs (E1, ..., E32) of the switching-network module, that each output (01, ..., 016) of a switching element of the last stage (SU21, ..., SU24) of a switching-network module is connected to one of the outputs (A1, ..., A32) of the switching-network module, that between the stages, the outputs of the switching elements of preceding stages are connected to the inputs of the switching elements of succeeding stages in such a way that one path is possible from every input of the switching-network module to every output of the switching-network module, and that the switching-network module has exactly such a number of stages that said one path is possible.

2. A switching network as claimed in claim 1, characterized in that each switching-network module (SM) is a two-stage (SU11, ..., SU14; SU21, ..., SU24) arrangement of switching elements, and that every switching element of the first stage is connected to every switching element of the second stage.

3. A switching network as claimed in claim 2, characterized in that groups of two or more outputs of a switching element of the first stage of a switching-network module are connected to groups of two or more inputs of a switching element of the second stage of the switching-network module.

4. Switching-network module (SM) for the switching network claimed in claim 1, having a plurality of inputs (E1, ..., E32) for receiving cells, a plurality of outputs (A1, ..., A32) for transmitting cells, and means for transferring a cell received at any input to any output,
**characterized in**
that it is a two- or multi-stage arrangement of switching elements, that each switching element (Fig. 5) has two or more inputs (I1, ..., I16), two or more outputs (01, ..., 016), means for transferring a cell received at any input to any output, and memories (PS) for buffering cells, and that each input (I1, ..., I16) of a switching element of the first stage (SU11, ..., SU14) of the switching-network module is connected to one of the inputs (E1, ..., E32) of the switching-network module, that each output (01, ..., 016) of a switching element of the last stage (SU21, ..., SU24) of the switching-network module is connected to one of the outputs (A1, ..., A32) of the switching-network module, that between the stages, the outputs of the switching elements of preceding stages are connected to the inputs of the switching elements of succeeding stages in such a way that one path is possible from every input of the switching-network module to every output of the switching-network module, and that the switching-network module has exactly such a number of stages that said one path is possible.

5. A switching network module as claimed in claim 4, characterized in that it is a two-stage (SU11, ..., SU14: SU21, ..., SU24) arrangement of switching elements, that each switching element (Fig. 5) has two or more inputs, two or more outputs, means for transferring a cell received at any input to any output, and memories (PS) for buffering cells, that each input of a switching element of the first stage (SU11, ..., SU14) is connected to one of the inputs (I1, ..., I32) of the switching-network module, that each output of a switching element of the second stage (SU21, ..., SU24) is connected to one of the outputs (01, ..., 032) of the switching-network module, and that every switching element of the first stage is connected to every switching element of the second stage.

6. A switching-network module as claimed in claim 4 or 5, characterized in that groups of two or more outputs of a switching element of a preceding stage are connected to groups of two or more inputs of a switching element of a succeding stage.

## Revendications

1. Réseau de couplage pour un système ATM, présentant des dispositifs de couplage (SM01,..., SM04 ; SM101, ..., SM132 ; SM201, ..., SM216) présentant des sorties pour la réception de cellules, des sorties pour l'émission de cellules, des moyens pour la transmission d'une cellule reçue à une quelconque entrée vers une quelconque sortie, et des mémoires (PS) pour la mémorisation temporaire de cellules, chaque cellule parcourant le réseau de couplage de façon que dans une première partie des dispositifs de couplage parcourus les sorties soient choisies indépendamment de la destination de la cellule, et dans une deuxième partie les sorties des dispositifs de couplage parcourus soient choisies en fonction de la destination de la cellule, caractérisé en ce que
les dispositifs de couplage sont des modules de réseau de couplage (SM) qui sont des dispositions d'éléments de réseau de couplage composées de deux ou plus de deux niveaux, en ce que chaque élément de réseau de couplage (figure 5) comprend deux ou plus de deux entrées, deux ou plus de deux sorties, un moyen de transmission d'une cellule reçue à une quelconque entrée vers une quelconque sortie, et une mémoire pour la mémorisation temporaire des cellules, en ce que chaque entrée (I1, I16) d'un élément de couplage du premier niveau (SU11, ..., SU14) d'un module de réseau de couplage est connectée à l'une des entrées (E1 ..., E32) de ce module de réseau de couplage, en ce que chaque sortie (01, ..., 016) d'un élément de réseau de couplage du dernier niveau (SU21, ..., SU24) d'un module de réseau de couplage est connectée à l'une des sorties (A1, ..., A32) de ce module du réseau de couplage, en ce que qu'entre les niveaux, les sorties des éléments de réseau de couplage des niveaux précédents sont connectées aux entrées des éléments de réseau de couplage des niveaux suivants de façon qu'une trajectoire soit possible de chaque entrée du module de réseau de couplage vers chaque sortie du module de réseau de couplage, et que le module de réseau de couplage présente exactement autant de niveaux que cela est possible à cette trajectoire.

2. Réseau de couplage selon la revendication 1, caractérisé en ce que chaque module de réseau de couplage (SM) est composé d'une disposition d'éléments de réseau de couplage composée de deux niveaux (SU11, ..., SU14 ; SU21,..., SU24), et en ce que chaque élément de réseau de couplage du premier niveau est connecté à chaque élément de réseau de couplage du second niveau.

3. Réseau de couplage selon la revendication 2, caractérisé en ce que chaque fois, plusieurs sorties d'un éléments de réseau de couplage du premier niveau d'un module de réseau de couplage sont connectées à plusieurs entrées d'un élément de couplage du second niveau du module de réseau de couplage.

4. Module de réseau de couplage (SM) pour le réseau de couplage selon la revendication 1, présentant une pluralité d'entrées (E1, ..., E32) pour la réception de cellules, une pluralité de sorties (A1, ..., A32) pour l'émission de cellules, et des moyens pour la transmission d'une cellule reçue à une quelconque entrée vers une quelconque sortie,
caractérisé en ce qu'il est composé d'une disposition d'éléments de réseau de couplage composée de deux ou plus de deux niveaux, en ce que chaque élément de réseau de couplage (figure 5) comprend deux ou plus de deux entrées (I1, ..., I16), deux ou plus de deux sorties (01, ..., 016), un moyen de transmission d'une cellule reçue à une quelconque entrée vers une quelconque sortie, et une mémoire (PS) pour la mémorisation temporaire des cellules, en ce que chaque entrée (I1, ..., I16) d'un élément de couplage du premier niveau (SU11, ..., SU14) du module de réseau de couplage est connectée à l'une des entrées (E1, ..., E32) du module de réseau de couplage, en ce que chaque sortie (01, ..., 016) d'un élément de réseau de couplage du dernier niveau (SU21, ..., SU24) du module de réseau de couplage est connectée à l'une des sorties (A1, ..., A32) du module de réseau de couplage, en ce que qu'entre les niveaux, les sorties des éléments de réseau de couplage des niveaux précédents sont connectées aux entrées des éléments de réseau de couplage des niveaux suivants, de façon qu'une trajectoire soit possible de chaque entrée du module de réseau de couplage vers chaque sortie du module de réseau de couplage, et que le module de réseau de couplage présente exactement autant de niveaux que cela est possible à cette trajectoire.

5. Module de réseau de couplage selon la revendication 4, caractérisé en ce qu'il est composé d'une disposition d'éléments de réseau de couplage composée de deux niveaux (SU11, ..., SU14 ; SU21,..., SU24), en ce que chaque élément de réseau de couplage (figure 5) comprend plusieurs entrées, plusieurs sorties, un moyen de transmission d'une cellule reçue à une quelconque entrée vers une quelconque sortie, et une mémoire (PS) pour la mémorisation temporaire des cellules, en ce que chaque entrée d'un élément de couplage du premier niveau (SU11, ..., SU14) d'un module de réseau de couplage est connectée à l'une des entrées (I1, ..., I32) de module de réseau de couplage, en ce que chaque sortie d'un élément de réseau de couplage du second niveau (SU21, ..., SU24) d'un module de réseau de couplage est connectée à l'une des sorties (01, ..., 032) du module de réseau de couplage, et en ce que chaque élément de réseau de couplage du premier niveau est connecté à chaque élément de réseau de couplage du second niveau.

6. Module de réseau de couplage selon les revendications 4 ou 5, caractérisé en ce que chaque fois, plusieurs sorties d'un élément de réseau de couplage d'un niveau précédent sont connectées à plusieurs entrées d'un élément de couplage d'un niveau suivant.
